# EUROPEAN PATENT SPECIFICATION

(11) **EP 3 270 674 B1**
(45) Date of publication and mention of the grant of the patent: **26.01.2022**
(21) Application number: 16767695.6
(22) Date of filing: 15.03.2016
(51) Int. Cl.: H05K 7/20

(54) **HEAT DISSIPATION APPARATUS, RADIO REMOTE UNIT, BASE STATION UNIT, COMMUNICATION BASE STATION AND SYSTEM**
WÄRMEABLEITUNGSVORRICHTUNG, FERNFUNKEINHEIT, BASISSTATIONSEINHEIT, KOMMUNIKATIONSBASISSTATION UND SYSTEM
APPAREIL DE DISSIPATION DE CHALEUR, UNITÉ RADIO À DISTANCE, UNITÉ DE STATION DE BASE, STATION DE BASE DE COMMUNICATION ET SYSTÈME

(30) Priority: 24.03.2015 CN 201510130461
(43) Date of publication of application: 17.01.2018
(73) Proprietor: Huawei Technologies Co., Ltd., Longgang District Shenzhen, Guangdong 518129 (CN)
(72) Inventor: YANG, Kaixiang, Shenzhen Guangdong 518129 (CN); HONG, Yuping, Shenzhen Guangdong 518129 (CN); SHI, Jian, Shenzhen Guangdong 518129 (CN); TANG, Yun, Shenzhen Guangdong 518129 (CN); TSOI, Vadim, Shenzhen Guangdong 518129 (CN)
(74) Representative: Epping - Hermann - Fischer
(86) International application number: PCT/CN2016/076378
(87) International publication number: WO 2016/150318

(56) References cited:
- WO-A1-97/34432
- CN-A- 101 645 714
- CN-A- 101 754 644
- CN-A- 103 717 036
- CN-A- 104 363 736
- CN-A- 104 768 355
- DE-A1- 3 223 624
- US-A- 5 437 328
- US-A1- 2001 003 304
- US-A1- 2010 177 478
- US-A1- 2013 292 105
- US-A1- 2014 043 767

## Description

### TECHNICAL FIELD

The present invention relates to the communications field, and in particular, to a heat dissipation apparatus, a radio remote unit, a base station module, a communications base station, and a communications system.

### BACKGROUND

An outdoor communications base station is generally provided with multiple base station modules, such as a radio remote unit (Radio Remote Unit, RRU), a baseband unit (Baseband unit , BBU), and a power module. In the prior art, an outdoor communications base station module still dissipates heat mainly by using a natural environment. Heat dissipation efficiency in an outdoor natural environment is low, especially when there is solar radiation but no wind. Consequently, because of an over-high temperature, efficiency of the outdoor communications base station module is reduced, and a temperature of a module needs to be reduced by reducing an output power, that is, by reducing a coverage area.

In the prior art, using a radio remote unit as an example, as communication bandwidth increases and a quantity of users dramatically increases, heat dissipation requirements of the radio remote unit becomes higher and higher, and a heat sink fin is usually disposed on an external side of the module to dissipate heat. However, heat dissipation efficiency of the heat sink fin is relatively low, and in a cascaded installation scenario, a spacing is formed between neighboring radio remote units; cold air flows through the spacing between the modules, and it is difficult for the cold air to flow into the heat sink fin disposed on the module. From WO 97/35432 base stations for use in communication systems and comprising heat sinks with cascades of duplicated heat sink elements are known. From US 2013/0292105 A1 heat sinks for natural-convection cool systems comprising heat sink fins and a horizontal wall are known. From US 2001/0003304 A1 heat sinks with textured heat sink fins are known. From DE 3223624 A1 heat sinks for electronic components having heat sink fins pointing in different directions are known. From US Patent 5,437,328 multi stage heat sinks for a balance between thermal conduction and convection are known.

### SUMMARY

A heat dissipation apparatus according to independent claim 1 is provided. Dependent claims provide preferred embodiments. A heat dissipation apparatus with a better heat dissipation effect, a radio remote unit, a base station module, a communications base station, and a communications system are provided.

The heat dissipation apparatus in the present invention may be disposed on an external side of the base station module of the communications base station. When the heat dissipation apparatus in the present invention is used, air at a bottom of the base station module absorbs heat emitted by the heat dissipation apparatus, circulates and rises along a spacing between neighboring first heat sink fins of the heat dissipation apparatus, and reduces heat of the heat dissipation apparatus in a circulation process. A baffle is further disposed, so that the air forms a turbulent flow in the circulation process, and deeply penetrates into a first dedendum of a first heat sink fin, thereby enhancing an effect of heat exchange between the heat dissipation apparatus and external cold air.

### BRIEF DESCRIPTION OF DRAWINGS

To describe the technical solutions in the embodiments of the present invention or in the prior art more clearly, the following briefly describes the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts within the scope of the appended claims.
FIG. 1 is a schematic structural diagram of a heat dissipation apparatus used in a base station module according to a first embodiment not falling within the scope of the claims;
FIG. 2 is an enlarged schematic diagram of a heat dissipation apparatus in FIG. 1;
FIG. 3 is schematic structural diagram of a heat dissipation apparatus used in a base station module according to a second embodiment not falling within the scope of the claims;
FIG. 4 is an enlarged schematic diagram of a heat dissipation apparatus in FIG. 3;
FIG. 5 is schematic structural diagram of a heat dissipation apparatus applied a base station module according to a third embodiment not falling within the scope of the claims;
FIG. 6 is an enlarged schematic diagram of a heat dissipation apparatus in FIG. 5;
FIG. 7 is a schematic structural diagram of a heat dissipation apparatus according to a fourth embodiment falling within the scope of the claims;
FIG. 8 is a schematic structural diagram of a heat dissipation apparatus according to a fifth embodiment not falling within the scope of the claims;
FIG. 9 is an enlarged schematic diagram of a heat dissipation apparatus in FIG. 8;
FIG. 10 is a schematic structural diagram of a heat dissipation apparatus according to a sixth embodiment not falling within the scope of the claims;
FIG. 11 is a schematic structural diagram of a heat dissipation apparatus according to a seventh embodiment not falling within the scope of the claims; and
FIG. 12 is a schematic structural diagram of a heat dissipation apparatus according to an eighth embodiment not falling within the scope of the claims.

### DESCRIPTION OF EMBODIMENTS

The following clearly and completely describes the technical solutions in the embodiments of the present invention defined by the claims with reference to the accompanying drawings. Apparently, the described embodiments are merely some but not all of the embodiments of the present invention. All other embodiments falling within the scope of the claims obtained by a person of ordinary skill in the art based on the embodiments of the present invention without creative efforts shall fall within the protection scope of the present invention.

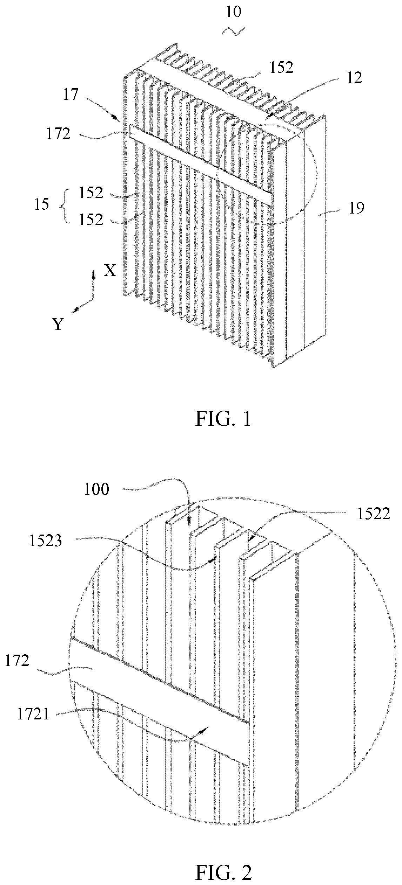

Referring to FIG. 1 and FIG. 2, a first embodiment not falling within the scope of the claims provides a heat dissipation apparatus 10 used in a base station module. The heat dissipation apparatus 10 is installed in the base station module, so as to dissipate heat from the base station module of a communications base station, and ensure that the base station module operates at an appropriate temperature. The communications base station module may include but is not limited to a radio remote unit (Radio Remote Unit, RRU), a baseband unit (Baseband unit, BBU), and a power module.

The heat dissipation apparatus 10 includes a housing 12, a first heat dissipation module 15, and a second heat dissipation module 17. The first heat dissipation module 15 is disposed on an external side of the housing 12 and is connected to the housing 12. It may be understood that in this embodiment, the housing 12 of the heat dissipation apparatus 10 may be the housing 12 of the base station module, and the housing 12 of the base station module may be configured to accommodate various electrical elements of the base station module and transfer heat to the first heat dissipation module 15 and the second heat dissipation module 17, so that the base station module dissipates the heat. The base station module may be provided with a separate module enclosure, and the housing 12 of the heat dissipation apparatus 10 may be connected to the module enclosure in any manner. It may be understood that a shape and an internal structure of the housing 12 may be set as required.

The base station module is further provided with a panel 19 that is connected to the housing 12 and an electrical element (not shown in the figure) that is disposed in the housing 12, such as various interface elements, transceiver elements, or optical demultiplexing/multiplexing elements. Structures and functions of the panel 19 and the electrical element that is disposed in the housing 12 are not described herein.

The first heat dissipation module 15 includes at least two first heat sink fins 152 disposed at intervals, and the first heat sink fin 152 is disposed on an external side of the housing 12. The first heat sink fin 152 is provided with a first dedendum 1522 and a first addendum 1523, and the first dedendum 1522 of the first heat sink fin 152 is connected to the housing 12. The first heat sink fin 152 is configured to absorb heat from the housing 12 and dissipate the heat to an external environment.

In this embodiment, the first heat sink fin 152 is strip-shaped and sheet-like. An edge that is of the first heat sink fin 152 and that is connected to the baffle is a long edge, and a neighboring edge of the long edge is a short edge. Asecond extension direction Y is a direction away from the housing 12, and afirst extension direction X is perpendicular to the first extension directionY.

In this embodiment, the housing is a cube, and the long edge of the first heat sink fin 152 extends in the first extension direction X parallel to the housing 12. The short edge of the first heat sink fin 152 is perpendicular to the first extension direction and extends in the second extension direction Y away from the housing 12.

The first heat sink fin 152 may be disposed on each surface that is of the housing 12 and requires enhanced heat dissipation. A spacing between two neighboring first heat sink fins 152 is used for air circulation, so that a passageway 100 for airflow circulation is formed. Air circulating outside the heat dissipation apparatus 10 circulates in the passageway 100, so that heat of the heat dissipation apparatus 10 is reduced.

The second heat dissipation module 17 includes a baffle 172. The baffle 172 is connected to the first addendum 1523 of the first heat sink fin 152, and receives heat from the first heat sink fin 152. In this embodiment, the baffle 172 is provided with a first surface (not shown in the figure) and a second surface 1721 that is disposed on the back of the first surface. The first heat sink fin 152 is connected to the first surface of the baffle 172.

In this embodiment, the baffle 172 is strip-shaped and plate-shaped, and the baffle 172 stretches across at least one passageway 100. Further, the baffle 172 may be approximately perpendicular to the first heat sink fin 152. It may be understood that the baffle 172 may be connected to the first addendum 1523 of the first heat sink fin 152 by means of welding, integrated molding, or in any other appropriate manners. It may be understood that a size of the baffle 172 may be set as required.

The heat dissipation apparatus 10 in the present invention may be disposed on an external side of a base station module of a communications base station. The first heat sink fin 152 absorbs and dissipates heat of the housing 12, and the baffle 172 is further disposed to implement secondary heat dissipation, so that an effect of heat exchange between the heat dissipation apparatus 10 and external cold air is enhanced. In addition, in a process in which an airflow flows through the heat dissipation apparatus 10, the baffle 172 is disposed to cover the passageway 100 formed by the first heat sink fin 152, so as to prevent airflow from flowing out of the passageway 100. This ensures that the airflow can deeply penetrate into the first dedendum 1522 of the first heat sink fin 152 in the passageway 100, thereby ensuring a heat dissipation effect for the first dedendum 1522 with a relatively high temperature.

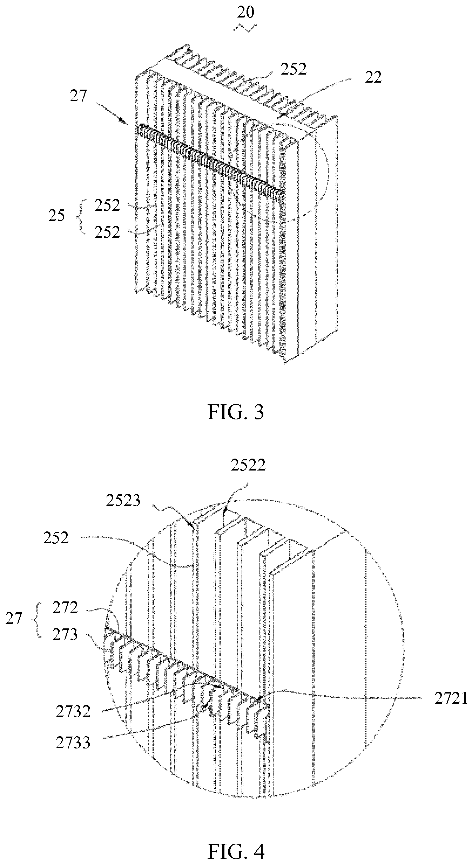

As shown in FIG. 3 and FIG. 4, a second embodiment not falling within the scope of the claims provides a heat dissipation apparatus 20. The heat dissipation apparatus 20 in this embodiment is approximately the same as that in the first embodiment, including a housing 22, a first heat dissipation module 25, and a second heat dissipation module 27. The first heat dissipation module 25 includes at least two first heat sink fins 252 that are disposed at intervals and that are disposed on an external side of the housing 22. The first heat sink fin 252 is provided with a first dedendum 2522 and a first addendum 2523, and the first dedendum 2522 of the first heat sink fin 252 is connected to the housing 22. The second heat dissipation module 27 includes a baffle 272, and the baffle 272 is connected to the first addendum 2523 of the first heat sink fin 252.

A difference lies in that in this embodiment, the second heat dissipation module 27 is further provided with a second heat sink fin 273, and the second heat sink fin 273 is provided with a second dedendum 2732 and a second addendum 2733. The second dedendum 2732 of the second heat sink fin 273 is connected to a side that is of the baffle 272 and that backs on to the first heat sink fin 252. The second heat sink fin 273 is disposed on a second surface 2721 of the baffle 272, and each second heat sink fin 273 protrudes from the second dedendum 2732 in a direction away from the baffle 272. In this embodiment, the heat dissipation apparatus 20 is provided with at least two second heat sink fins 273 that are disposed at intervals. It may be understood that a quantity of second heat sink fins 273 and a spacing may be set as required.

A fin spacing and a fin thickness of the second heat sink fin 273 may be set to improve efficiency of heat exchange between the second heat sink fin 273 and external cold air, so as to improve an overall heat dissipation effect of the heat dissipation apparatus 20. Preferably, a fin thickness of the second heat sink fin 273 is less than a fin thickness of the first heat sink fin 252. A fin spacing between the two neighboring second heat sink fins 273 is less than a fin spacing between the two neighboring first heat sink fins 252. According to the heat dissipation apparatus 20 in this embodiment, the second heat sink fin 273 is disposed on the baffle 272, so that a heat dissipation capability of the second heat dissipation module 27 is improved, thereby improving an overall heat dissipation effect of the heat dissipation apparatus 20.

Further, during usage, in a processing in which air circulates and rises, the second heat sink fin 273 may cause a turbulent flow effect on circulated air, accelerate air circulation in a passageway 200 between two neighboring first heat sink fins 252, and make the air relatively close to the first dedendum 2522 of the first heat sink fin 252, so as to improve a heat dissipation effect of the heat dissipation apparatus 20.

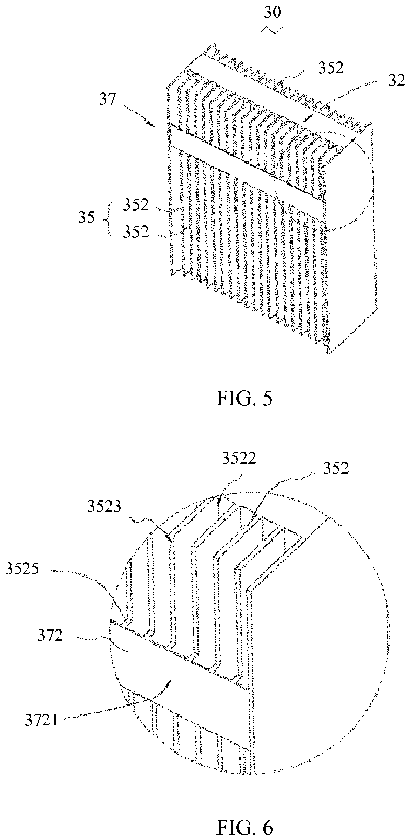

As shown in FIG. 5 and FIG. 6, a third embodiment not falling within the scope of the claims provides a heat dissipation apparatus 30. The heat dissipation apparatus 30 in this embodiment is approximately the same as that in the first embodiment, including a housing 32, a first heat dissipation module 35, and a second heat dissipation module 37. The first heat dissipation module 35 includes at least two first heat sink fins 352 that are disposed at intervals and that are disposed on an external side of the housing 32. The first heat sink fin 352 is provided with a first dedendum 3522 and a first addendum 3523, and the first dedendum 3522 of the first heat sink fin 352 is connected to the housing 32. The second heat dissipation module 37 is provided with a baffle 372, and the baffle 372 is provided with a first surface and a second surface 3721.

A difference lies in that in this embodiment, the first addendum 3523 of each first heat sink fin 352 of the first heat dissipation module 35 is provided with a protrusion 3525. The protrusion 3525 is located on a plane in which the first heat sink fin 352 is located, and protrudes in a direction away from the first dedendum 3522. The first surface of the baffle 372 is connected to and covers the protrusion 3525 of the first addendum 3523.

It may be understood that the first addendum 3523 of each first heat sink fin 352 may be provided with a first protrusion 3525, and shapes and protrusion sizes of all first protrusions 3525 may be the same, so that the baffle 372 is seamlessly connected to the first heat sink fin 35.

According to the heat dissipation apparatus 30 in this embodiment, the first protrusion 3525 is disposed, so that a heat dissipation effect of space between the baffle 372 and the housing 32 is improved, and a heat dissipation effect of the first heat dissipation module 35 is improved, thereby further improving an overall heat dissipation effect of the heat dissipation apparatus 30.

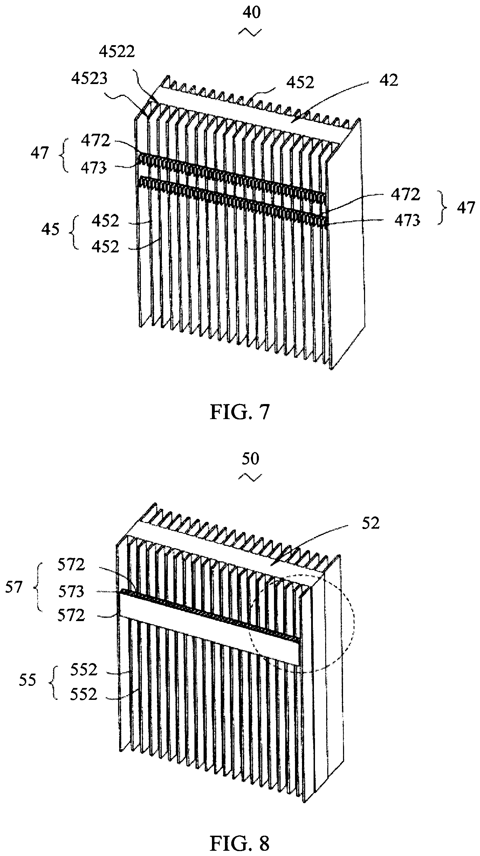

As shown in FIG. 7, a fourth embodiment falling within the scope of the claims provides a heat dissipation apparatus 40. The heat dissipation apparatus 40 in this embodiment is approximately the same as that in the second embodiment, including a housing 42, a first heat dissipation module 45, and a second heat dissipation module 47. The first heat dissipation module 45 includes at least two first heat sink fins 452 that are disposed at intervals and that are disposed on an external side of the housing 42. The first heat sink fin 452 is provided with a first dedendum 4522 and a first addendum 4523, and the first dedendum 4522 of the first heat sink fin 452 is connected to the housing 42. The second heat dissipation module 47 includes a baffle 472 and a second heat sink fin 473 connected to the baffle 472. The baffle 472 is connected to the first addendum 4523 of the first heat sink fin 452.

A difference lies in that in this embodiment, at least two second heat dissipation modules 47 are disposed. The baffles 472 of the at least two second heat dissipation modules 47 are separately connected to the first addendums 4523 of the first heat sink fins 452.

Further, the at least two second heat dissipation modules 47 are disposed at intervals and are arranged in order in the first extension direction. The baffles 472 of the first heat dissipation module 45 are mutually parallel in a long edge direction.

In this embodiment, multiple groups of second heat dissipation modules 47 are disposed, so that an overall heat dissipation effect and a turbulent flow effect of the heat dissipation apparatus 40 are enhanced.

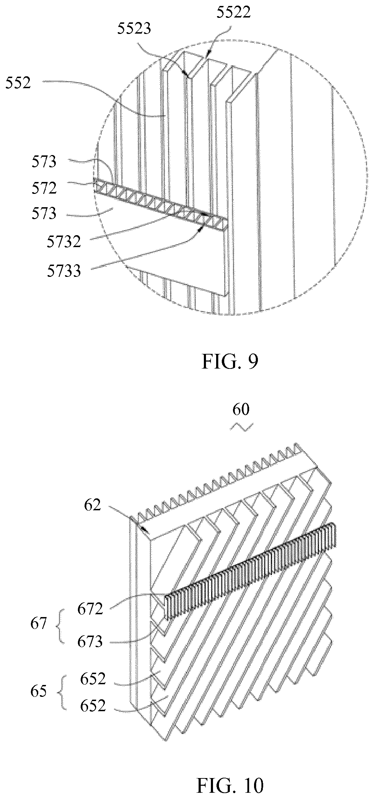

As shown in FIG. 8 and FIG. 9, a fifth embodiment not falling within the scope of the claims provides a heat dissipation apparatus 50. The heat dissipation apparatus 50 in this embodiment is approximately the same as that in the second embodiment, including a housing 52, a first heat dissipation module 55, and a second heat dissipation module 57. The first heat dissipation module 55 includes at least two first heat sink fins 552 that are disposed at intervals and that are disposed on an external side of the housing 52. The first heat sink fin 552 is provided with a first dedendum 5522 and a first addendum 5523, and the first dedendum 5522 of the first heat sink fin 552 is connected to the housing 52. The second heat dissipation module 57 includes a baffle 572 and a second heat sink fin 573 connected to the baffle 572. The second heat sink fin 573 is provided with a second dedendum 5732 and a second addendum 5733.

A difference lies in that in this embodiment, at least two baffles 573 of the second heat dissipation modules 57 are disposed. A baffle 573 that is in the at least two baffles 573 and that is closest to the first heat sink fin 552 is directly connected to the first addendum 5523 of the first heat sink fin 552, and the second heat sink fin 573 connected to two neighboring baffles 573 is disposed between every two neighboring baffles 573. Each second addendum 5733 is located at an end opposite to the second dedendum 5732 of the second heat sink fin 573.

As shown in FIG. 10, a sixth embodiment not falling within the scope of the claims provides a heat dissipation apparatus 60. The heat dissipation apparatus 60 in this embodiment is approximately the same as that in the third embodiment, including a housing 62, a first heat dissipation module 65, and a second heat dissipation module 67. The first heat dissipation module 65 includes at least two first heat sink fins 652 that are disposed at intervals and that are disposed on an external side of the housing 62. The first heat sink fin 652 is connected to the housing 62. The second heat dissipation module 67 includes a baffle 672 and a second heat sink fin 673 connected to the baffle 672. The baffle 672 is connected to the first heat sink fin 652.

A difference lies in that in this embodiment, the second heat sink fin 673 is disposed obliquely relative to the first heat sink fin 652.

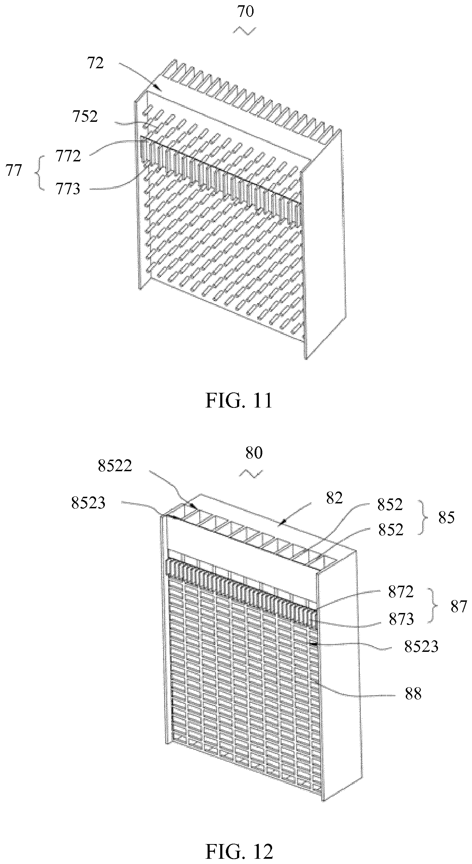

As shown in FIG. 11, a seventh embodiment not falling within the scope of the claims provides a heat dissipation apparatus 70. The heat dissipation apparatus 70 in this embodiment is approximately the same as that in the third embodiment, including a housing 72, a first heat dissipation module, and a second heat dissipation module 77. The first heat dissipation module includes at least two first heat sink fins 752 that are disposed at intervals and that are disposed on an external side of the housing 72. The first heat sink fin 752 is connected to the housing 72. The second heat dissipation module 77 includes a baffle 772 and a second heat sink fin 773 connected to the baffle 772. The baffle 772 is connected to the first heat sink fin 752.

A difference lies in that in this embodiment, the first heat sink fin 752 is columnar. In this embodiment, a fin thickness of the first heat sink fin 752 refers to a diameter of the first heat sink fin 752. It may be understood that a first heat sink fin 752 disposed on one side of the housing 72 of the heat dissipation apparatus 70 may be columnar, and a first heat sink fin 752 disposed on the other side of the housing 72 may be the same as that in the first embodiment and is set to be sheet-like.

Further, the second heat sink fin 773 may also be set to be columnar.

As shown in FIG. 12, an eighth embodiment not falling within the scope of the claims provides a heat dissipation apparatus 80. The heat dissipation apparatus 80 in this embodiment is approximately the same as that in the third embodiment, including a housing 82, a first heat dissipation module 85, and a second heat dissipation module 87. The first heat dissipation module 85 includes at least two first heat sink fins 852 that are disposed at intervals and that are disposed on an external side of the housing 82. The first heat sink fin 852 is provided with a first dedendum 8522 and a first addendum 8523, and the first dedendum 8522 of the first heat sink fin 852 is connected to the housing 82. The second heat dissipation module 87 includes a baffle 872 and a second heat sink fin 873 connected to the baffle 872.

A difference lies in that in this embodiment, the heat dissipation apparatus 80 is further provided with at least one heat sink strip 88 that is built in the first addendum 8523 of the first heat sink fin 852. Further, in this embodiment, the first heat dissipation module 85 is disposed on a single side of the housing 82.

It may be understood by a person skilled in the art that two components in this embodiment of the present invention are parallel or perpendicular with an allowable error within a specific range. For example, an included angle between two components may be 0° to 20°. The present invention further provides a radio remote unit, including the foregoing heat dissipation apparatus 40 and the electrical elements accommodated in the housing of the heat dissipation apparatus 40.

The present invention further provides a base station module, including the foregoing heat dissipation apparatus 40 and the electrical elements accommodated in the housing 42 the heat dissipation apparatus 40. It should be understood that the base station module may be a baseband unit (BBU), a power module, a battery module, or the like. This embodiment of the present invention imposes no limitation.

The present invention further provides a communications base station, including the foregoing at least two base station modules. The at least two base station modules are mutually cascaded, and the baffle and a second heat sink fin connected to the baffle are disposed in a spacing between the two neighboring base station modules.

The second heat sink fin is disposed between the mutually cascaded base station modules, so as to prevent circulated air from directly circulating in a spacing between neighboring base station modules. Air is retained between neighboring first heat sink fins as much as possible, so that random air circulation is avoided, and the air is close to a first dedendum of the first heat sink fin, thereby improving a heat dissipation effect of the heat dissipation apparatus.

The present invention further provides a communications system, including the foregoing communications base station.

What are disclosed above are merely example embodiments of the present invention, and certainly are not intended to limit the protection scope of the present invention. A person of ordinary skill in the art may understand that all or some of processes that implement the foregoing embodiments and equivalent modifications made in accordance with the claims of the present invention shall fall within the scope of the present invention.

## Claims

1. A heat dissipation apparatus (40), comprising:
a housing (42), wherein the housing (42), is configured to accommodate an electrical element; and
at least two first heat sink fins (452) protruding outwards are disposed at intervals on an outer surface of the housing (42), a passageway (100) for airflow circulation is formed between two neighboring first heat sink fins (452), each first heat sink fin (452) comprises a first dedendum (4522) and a first addendum (4523), (1523),and the first dedendum (4522) of each first heat sink fin (452) is connected to the housing (42); and
a baffle (472), wherein a first surface of the baffle (472) is connected to first addendums (4523) of the at least two first heat sink fins (452) and stretches across at least one passageway (100),
wherein at least two second heat sink fins (273) are disposed on a second surface of the baffle (472) the second surface is the back of the first surface, each second heat sink fin (273) comprises a second dedendum (2732), the second dedendum (2732) of each second heat sink fin (273) is connected to a backside of the baffle (472) relative to the first heat sink fin (452), and each second heat sink fin (273) protrudes from the second dedendum (2732) in a direction away from the baffle (472),
**characterized in that** a fin spacing between two neighboring second heat sink fins (273) is less than a fin spacing between the two neighboring first heat sink fins (452), wherein at least two baffles (472) are disposed, each baffle (472) is connected to the at least two first heat sink fins (452), and all the second heat sink fins (273) on each baffle (472) are mutually parallel.

2. The heat dissipation apparatus (40) according to claim 1, wherein the baffle (472) is perpendicular to each first heat sink fin 2. (452).

3. The heat dissipation apparatus (40) according to claim 1 or 2, wherein the first addendum (4523) of each first heat sink fin (452) is provided with a protrusion (3525), each protrusion (3525) protrudes in a direction away from the first dedendum (4522), and the first surface of the baffle (472) is connected to and covers the protrusion (3525) of the first addendum (4523).

4. The heat dissipation apparatus (40) according to any one of claims 1 to 3, wherein a fin thickness of each second heat sink fin (273) is less than a fin thickness of each first heat sink fin (452).

5. The heat dissipation apparatus (40) according to any one of claims 1 to 4, wherein at least two baffles (472,572) are disposed, the baffles (472,572) are mutually overlapped and disposed at intervals, a first surface of a baffle (472,572) that is in the at least two baffles (472,572) and that is closest to the first heat sink fin (452) is connected to the first addendum (4523) (1523) of the first heat sink fin (452), the second heat sink fin (273) is disposed between every two baffles (472, 572), the second dedendum (2732) of each second heat sink fin (273) is connected to one of two neighboring baffles (472, 572), each second heat sink fin (273) further comprises a second addendum, the second addendum is located at an end opposite to the second dedendum (2732) of each second heat sink fin (273), and the second addendum of each second heat sink fin (273) is connected to the respective other of the two neighboring baffles (472, 572).

6. The heat dissipation apparatus (40) according to any one of claims 1 or 5, wherein each second heat sink fin (273) is disposed obliquely relative to each first heat sink fin (452).

7. The heat dissipation apparatus (40) according to any one of claims 1 to 6, wherein the first heat sink fin (452) is sheet-like or columnar.

8. The heat dissipation apparatus (40) according to any one of claims 1 to 7, wherein the heat dissipation apparatus (40) is further provided with at least one heat sink strip (88) that is connected to the first addendum (4523) of the first heat sink fin (452)

9. A radio remote unit, comprising the heat dissipation apparatus (40) and the electrical element accommodated in the housing (42) of the heat dissipation apparatus (40) according to any one of claims 1 to 8.

10. Abase station module, comprising the heat dissipation apparatus (40) and the electrical element accommodated in the housing (42) of the heat dissipation apparatus (40) according to any one of claims 1 to 8.

11. A communications base station, comprising the at least two communications base station modules according to claim 10, wherein the at least two communications base station modules are disposed in a neighboring manner and are mutually cascaded, a spacing is provided between first addendums (4523) of first heat sink fins (452) of two neighboring base station modules, and the baffle (472) and a second heat sink fin (273) connected to the baffle (472) are disposed in the spacing.

12. A communications system, comprising the communications base station according to claim 11.

## Patentansprüche

1. Wärmeableitungsvorrichtung (40), die Folgendes umfasst:
ein Gehäuse (42), wobei das Gehäuse (42) dazu ausgebildet ist, ein elektrisches Element aufzunehmen; und
mindestens zwei erste Kühlkörperrippen (452), die nach außen vorstehen und in Abständen auf einer Außenfläche des Gehäuses (42) angeordnet sind,
einen Durchgang (100) für die Zirkulation des Luftstroms, der zwischen zwei benachbarten ersten Kühlkörperrippen (452) gebildet wird,
wobei jede erste Kühlkörperrippe (452) ein erstes Fußende (4522) und ein erstes Kopfende (4523) umfasst, und
das erste Fußende (4522) jeder ersten Kühlkörperrippe (452) mit dem Gehäuse (42) verbunden ist; und
eine Ablenkplatte (472), wobei eine erste Oberfläche der Ablenkplatte (472) mit ersten Kopfenden (4523) der mindestens zwei ersten Kühlkörperrippen (452) verbunden ist und sich über mindestens einen Durchgang (100) erstreckt,
wobei mindestens zwei zweite Kühlkörperrippen (273) auf einer zweiten Oberfläche der Ablenkplatte (472) angeordnet sind,
die zweite Oberfläche die Rückseite der ersten Oberfläche ist,
jede zweite Kühlkörperrippe (273) ein zweites Fußende (2732) umfasst,
das zweite Fußende (2732) jeder zweiten Kühlkörperrippe (273) mit einer Rückseite der Ablenkplatte (472) relativ zur ersten Kühlkörperrippe (452) verbunden ist, und
jede zweite Kühlkörperrippe (273) von dem zweiten Fußende (2732) in einer Richtung weg von der Ablenkplatte (472) vorspringt,
**dadurch gekennzeichnet, dass** ein Rippenabstand zwischen zwei benachbarten zweiten Kühlkörperrippen (273) kleiner ist als ein Rippenabstand zwischen den beiden benachbarten ersten Kühlkörperrippen (452),
wobei mindestens zwei Ablenkplatten (472) angeordnet sind,
jede Ablenkplatte (472) mit den mindestens zwei ersten Kühlkörperrippen (452) verbunden ist, und
alle zweiten Kühlkörperrippen (273) an jeder Ablenkplatte (472) zueinander parallel sind.

2. Wärmeableitungsvorrichtung (40) gemäß Anspruch 1, wobei die Ablenkplatte (472) senkrecht zu jeder ersten Kühlkörperrippe (452) steht.

3. Wärmeableitungsvorrichtung (40) gemäß Anspruch 1 oder 2, wobei das erste Kopfende (4523) jeder ersten Kühlkörperrippe (452) mit einem Vorsprung (3525) versehen ist, jeder Vorsprung (3525) in einer Richtung weg von dem ersten Fußende (4522) vorsteht und die erste Oberfläche der Ablenkplatte (472) mit dem Vorsprung (3525) des ersten Kopfendes (4523) verbunden ist und diesen abdeckt.

4. Wärmeableitungsvorrichtung (40) gemäß einem beliebigen der Ansprüche 1 bis 3, wobei eine Rippendicke jeder zweiten Kühlkörperrippe (273) geringer ist als eine Rippendicke jeder ersten Kühlkörperrippe (452).

5. Wärmeableitungsvorrichtung (40) gemäß einem der Ansprüche 1 bis 4, wobei mindestens zwei Ablenkplatten (472, 572) angeordnet sind,
die Ablenkplatten (472, 572) sich gegenseitig überlappen und in Abständen angeordnet sind,
eine erste Oberfläche einer Ablenkplatte (472, 572), die sich in den mindestens zwei Ablenkplatten (472, 572) befindet und die der ersten Kühlkörperrippe (452) am nächsten ist, mit dem ersten Kopfende (4523) der ersten Kühlkörperrippe (452) verbunden ist,
die zweite Kühlkörperrippe (273) zwischen jeweils zwei Ablenkplatten (472, 572) angeordnet ist,
das zweite Fußende (2732) jeder zweiten Kühlkörperrippe (273) mit einer der beiden benachbarten Ablenkplatten (472, 572) verbunden ist,
jede zweite Kühlkörperrippe (273) ferner ein zweites Kopfende umfasst,
das zweite Kopfende an einem Ende gegenüber dem zweiten Fußende (2732) jeder zweiten Kühlkörperrippe (273) positioniert ist, und
das zweite Kopfende jeder zweiten Kühlkörperrippe (273) mit der jeweils anderen der beiden benachbarten Ablenkplatten (472, 572) verbunden ist.

6. Wärmeableitungsvorrichtung (40) gemäß einem der Ansprüche 1 oder 5, wobei jede zweite Kühlkörperrippe (273) schräg zu jeder ersten Kühlkörperrippe (452) angeordnet ist.

7. Wärmeableitungsvorrichtung (40) gemäß einem der Ansprüche 1 bis 6, wobei die erste Kühlkörperrippe (452) plattenförmig oder säulenförmig ist.

8. Wärmeableitungsvorrichtung (40) gemäß einem beliebigen der Ansprüche 1 bis 7, wobei die Wärmeableitungsvorrichtung (40) ferner mit mindestens einem Kühlkörperstreifen (88) versehen ist, der mit dem ersten Kopfende (4523) der ersten Kühlkörperrippe (452) verbunden ist.

9. Fernfunkeinheit, die die Wärmeableitungsvorrichtung (40) und das in dem Gehäuse (42) der Wärmeableitungsvorrichtung (40) untergebrachte elektrische Element gemäß einem der Ansprüche 1 bis 8 umfasst.

10. Basisstationsmodul, das die Wärmeableitungsvorrichtung (40) und das in dem Gehäuse (42) der Wärmeableitungsvorrichtung (40) untergebrachte elektrische Element gemäß einem der Ansprüche 1 bis 8 umfasst.

11. Kommunikations-Basisstation, die die mindestens zwei Kommunikations-Basisstationsmodule gemäß Anspruch 10 umfasst,
wobei die mindestens zwei Kommunikations-Basisstationsmodule in einer benachbarten Weise angeordnet und gegenseitig kaskadiert sind,
ein Zwischenraum zwischen ersten Kopfenden (4523) von ersten Kühlkörperrippen (452) von zwei benachbarten Basisstationsmodulen vorgesehen ist, und
die Ablenkplatte (472) und eine zweite Kühlkörperrippe (273), die mit der Ablenkplatte (472) verbunden ist, in dem Zwischenraum angeordnet sind.

12. Kommunikationssystem, das die Kommunikations-Basisstation gemäß Anspruch 11 umfasst.

## Revendications

1. Appareil de dissipation thermique (40), comprenant :
un boîtier (42), le boîtier (42) étant configuré pour loger un élément électrique ; et
au moins deux premières ailettes de dissipation thermique (452) faisant saillie vers l'extérieur sont disposées à des intervalles sur une surface externe du boîtier (42),
une voie de passage (100) pour la circulation de flux d'air est formée entre deux premières ailettes de dissipation thermique (452) voisines, chaque première ailette de dissipation thermique (452) comprend un premier dedendum (4522) et un premier addendum (4523), et le premier dedendum (4522) de chaque première ailette de dissipation thermique (452) est connecté au boîtier (42) ; et
un déflecteur (472), une première surface du déflecteur (472) étant connectée aux premiers addenda (4523) des deux premières ailettes de dissipation thermique (452), ou plus, et s'étend à travers au moins une voie de passage (100),
dans lequel au moins deux secondes ailettes de dissipation thermique (273) sont disposées sur une seconde surface du déflecteur (472),
la seconde surface est l'arrière de la première surface, chaque seconde ailette de dissipation thermique (273) comprend un second dedendum (2732), le second dedendum (2732) de chaque seconde ailette de dissipation thermique (273) est connecté à un côté arrière du déflecteur (472) par rapport à la première ailette de dissipation thermique (452), et
chaque seconde ailette de dissipation thermique (273) fait saillie à partir du second dedendum (2732) dans une direction éloignée du déflecteur (472),
**caractérisé en ce que**
un espacement des ailettes entre deux secondes ailettes de dissipation thermique (273) voisines est inférieur à un espacement des ailettes entre les deux premières ailettes de dissipation thermique (452) voisines,
dans lequel au moins deux déflecteurs (472) sont disposés, chaque déflecteur (472) est connecté aux deux premières ailettes de dissipation thermique (452), ou plus,
et toutes les secondes ailettes de dissipation thermique (273) sur chaque déflecteur (472) sont mutuellement parallèles.

2. Appareil de dissipation thermique (40) selon la revendication 1, dans lequel le déflecteur (472) est perpendiculaire à chaque première ailette de dissipation thermique (452).

3. Appareil de dissipation thermique (40) selon la revendication 1 ou 2, dans lequel le premier addendum (4523) de chaque première ailette de dissipation thermique (452) est pourvu d'une saillie (3525), chaque saillie (3525) fait saillie dans une direction éloignée du premier dedendum (4522), et la première surface du déflecteur (472) est connectée à la saillie (3525) du premier addendum (4523), et la recouvre.

4. Appareil de dissipation thermique (40) selon l'une quelconque des revendications 1 à 3, dans lequel une épaisseur d'ailette de chaque seconde ailette de dissipation thermique (273) est inférieure à une épaisseur d'ailette de chaque première ailette de dissipation thermique (452).

5. Appareil de dissipation thermique (40) selon l'une quelconque des revendications 1 à 4, dans lequel au moins deux déflecteurs (472, 572) sont disposés, les déflecteurs (472, 572) se chevauchent mutuellement et sont disposés à des intervalles, une première surface d'un déflecteur (472, 572) qui se trouve dans les deux déflecteurs (472, 572), ou plus, et qui est la plus proche de la première ailette de dissipation thermique (452) est connectée au premier addendum (4523) de la première ailette de dissipation thermique (452), la seconde ailette de dissipation thermique (273) est disposée entre chaque paire de déflecteurs (472, 572), le second dedendum (2732) de chaque seconde ailette de dissipation thermique (273) est connecté à un des deux déflecteurs (472, 572) voisins, chaque seconde ailette de dissipation thermique (273) comprend en outre un second addendum, le second addendum est situé au niveau d'une extrémité opposée au second dedendum (2732) de chaque seconde ailette de dissipation thermique (273), et le second addendum de chaque seconde ailette de dissipation thermique (273) est connecté à l'autre déflecteur respectif parmi les deux déflecteurs (472, 572) voisins.

6. Appareil de dissipation thermique (40) selon l'une quelconque des revendications 1 et 5, dans lequel chaque seconde ailette de dissipation thermique (273) est disposée de manière oblique par rapport à chaque première ailette de dissipation thermique (452).

7. Appareil de dissipation thermique (40) selon l'une quelconque des revendications 1 à 6, dans lequel la première ailette de dissipation thermique (452) est en forme de feuille ou en colonne.

8. Appareil de dissipation thermique (40) selon l'une quelconque des revendications 1 à 7, l'appareil de dissipation thermique (40) étant pourvu en outre d'au moins une bande de dissipation thermique (88) qui est connectée au premier addendum (4523) de la première ailette de dissipation thermique (452).

9. Unité distante radio, comprenant l'appareil de dissipation thermique (40) et l'élément électrique logé dans le boîtier (42) de l'appareil de dissipation thermique (40) selon l'une quelconque des revendications 1 à 8.

10. Module de station de base, comprenant l'appareil de dissipation thermique (40) et l'élément électrique logé dans le boîtier (42) de l'appareil de dissipation thermique (40) selon l'une quelconque des revendications 1 à 8.

11. Station de base de communication, comprenant les deux modules de station de base de communication, ou plus, selon la revendication 10, les deux modules de station de base de communication, ou plus, étant disposés de manière voisine et étant mutuellement en cascade, un espacement étant prévu entre les premiers addendum (4523) des premières ailettes de dissipation thermique (452) des deux modules de station de base voisins, et le déflecteur (472) et une seconde ailette de dissipation thermique (273) connectée au déflecteur (472) étant disposés dans l'espacement.

12. Système de communication, comprenant la station de base de communication selon la revendication 11.
